Europäisches Patentamt

European Patent Office

Office européen des brevets

(11) Veröffentlichungsnummer: **0 258 516 B1**

(12) **EUROPÄISCHE PATENTSCHRIFT**

(45) Veröffentlichungstag der Patentschrift: **22.04.92**

(51) Int. Cl.5: **G01R 31/02**, G01R 19/14

(21) Anmeldenummer: **87100707.6**

(22) Anmeldetag: **20.01.87**

(54) **Verfahren und Einrichtung zur Erkennung der Polarität gepolter Kondensatoren.**

(30) Priorität: **01.08.86 DE 3626037**

(43) Veröffentlichungstag der Anmeldung:
**09.03.88 Patentblatt 88/10**

(45) Bekanntmachung des Hinweises auf die Patenterteilung:
**22.04.92 Patentblatt 92/17**

(84) Benannte Vertragsstaaten:
**CH DE GB LI**

(56) Entgegenhaltungen:
**EP-A- 0 185 255**
**DE-B- 1 206 082**

**IBM TECHNICAL DISCLOSURE BULLETIN, Band 27, Nr. 10A, März 1985, Seiten 5654-5655, New York, US; "Circuit for determining electrolytic capacitor polarity"**

**A.GÜNTHERSCHULZE et al.: "Elektrolyt-Kondensatoren", 1937, Seiten 126,136-137, Verlag von M. KRAYN, Berlin, DE**

(73) Patentinhaber: **SIEMENS AKTIENGESELLSCHAFT**
**Wittelsbacherplatz 2**
**W-8000 München 2(DE)**

(72) Erfinder: **Aldinger, Ulrich**
**Zittelstr. 4**
**W-8000 München 40(DE)**

## Beschreibung

Die Erfindung betrifft ein Verfahren zur Erkennung der Polarität gepolter Kondensatoren, insbesondere von Tantal- und Aluminium-Elektrolytkondensatoren bei der automatischen Bestückung von Leiterplatten oder Keramiksubstraten, bei dem die Kapazität eines zu prüfenden Kondensators mittels einer Wechselspannung ermittelt wird, sowie eine Einrichtung zur Durchführung dieses Verfahrens.

Bei der automatischen Bestückung von Leiterplatten oder Keramiksubstraten mit elektronischen Bauteilen, wie Widerständen, Kondensatoren, Dioden, Transistoren, Chips und dergleichen werden die verschiedenen Bauteile in seitlich angeordneten Zuführeinrichtungen bereitgestellt. Die Entnahme der Bauteile erfolgt dann über einen Bestückkopf, welcher das jeweils in einer Entnahmeposition bereitgestellte Bauteil erfaßt, mit Hilfe von vier paarweise angeordneten, zangenförmigen Hebeln zentriert und auf einer vorbestimmten Stelle der Leiterplatte oder des Keramiksubstrats ablegt. Die mit derartigen, beispielsweise aus der US-A- 4 135 630 bekannten Bestückautomaten erzielbare Bestückungssicherheit hängt in entscheidender Weise davon ab, daß der auf die Entnahmeposition der Zuführeinrichtungen programmierte Bestückkopf die Bauteile dort auch stets in der richtigen Lage antrifft und in der programmierten Bestückposition der Leiterplatte oder des Keramiksubstrats ebenfalls in der richtigen Lage ablegt.

Bei einem aus der DE-A- 3 102 206 bekannten Bestückkopf besteht zumindest das untere Ende der zur Aufnahme der Bauteile dienenden Saugpipette aus elektrisch nichtleitendem Werkstoff, wobei die mit dem elektronischen Bauteil zusammenwirkenden zangenförmigen Enden der Hebel elektrisch isoliert angeordnet sind. Durch diese Maßnahme kann dann über ein Hebelpaar ein bestimmter Strom eingespeist werden oder es kann über ein Hebelpaar eine bestimmte Spannung angelegt werden. Insbesondere besteht die Möglichkeit, die elektrischen Eigenschaften des jeweils vom Bestückkopf erfaßten Bauteils zu messen bzw. zu prüfen. Eine für die automatische Bestückung unbedingt erforderliche Erkennung der Polarität gepolter Kondensatoren ist mit dem geschilderten Bestückkopf jedoch nicht möglich, da bislang keine geeigneten elektrischen Erkennungsverfahren bekannt sind.

Aus der EP-A-0 185 255 sind ein Verfahren und eine Einrichtung zur Erkennung der Polarität gepolter Kondensatoren bekannt, bei welchen die bei Anlegen von Wechselspannungen an die elektrischen Anschlüsse des Kondensators kapazitiv über den Außenbelag zu einer Sonde fließenden Ströme als Signal für die Polarität des Kondensators ausgewertet werden. Die Sonde kann beispielsweise als metallisches Formteil ausgebildet werden, das in etwa eine Negativform für den darin aufzunehmenden Kondensator bildet.

Der Erfindung liegt die Aufgabe zugrunde, ein Verfahren und eine Einrichtung zur Erkennung der Polarität gepolter Kondensatoren zu schaffen, welche insbesondere bei der automatischen Bestückung von Leiterplatten oder Keramiksubstraten eine einfache und zuverlässige Polaritätserkennung von Tantal- und Aluminium-Elektrolytkondensatoren ermöglichen.

Diese Aufgabe wird bei dem Verfahren erfindungsgemäß dadurch gelöst, daß der Wechselspannung abwechselnd eine positive Gleichspannung und eine negative Gleichspannung gleichen Betrags überlagert wird und daß aus der Differenz der beiden daraus ermittelten Kapazitäten die Polarität des Kondensators bestimmt wird.

Der Erfindung liegt die Erkenntnis zugrunde, daß bei einer richtigen Polung von Elektrolytkondensatoren eine kleinere Kapazität gemessen wird als bei einer falschen Polung. Dies ist darauf zurückzuführen, daß bei einer richtigen Polung das aus einer Metalloxidschicht bestehende Dielektrikum durch Sauerstoffaufnahme gestärkt wird, während sich bei einer falschen Polung durch Sauerstoffentzug eine Schwächung ergibt. Die Verringerung der Stärke des Dielektrikums führt dann zwangsläufig zu einer höheren Kapazität. Obwohl die Unterschiede zwischen den Kapazitäten bei richtiger und falscher Polung insbesondere wegen der kleinen zulässigen Spannungen gering sind, können durch den Vergleich beider Messungen absolut zuverlässige Aussagen über die Polarität der gemessenen Kondensatoren gewonnen werden.

Gemäß einer weiteren Ausgestaltung der Erfindung wird eine sinusförmige Wechselspannung mit einer konstanten Frequenz verwendet. Derartige sinusförmige Wechselspannungen ermöglichen besonders einfache Kapazitätsmessungen.

Weiterhin ist es besonders günstig, wenn eine Wechselspannung mit einer von Null aus gemessenen Amplitude von ± 0,25 Volt verwendet wird. Dieser Wechselspannung wird dann vorzugsweise eine Gleichspannung von ± 0,25 Volt überlagert. Bei einer derartigen Bemessung wird berücksichtigt, daß einerseits bereits bei Spannungen ab 0,5 Volt die Gefahr einer Zerstörung des Kondensators besteht und daß andererseits höhere überlagerte Gleichspannungen zu deutlicheren Unterschieden der beiden gemessenen Kapazitäten führen.

Gemäß einer bevorzugten Ausgestaltung der Erfindung ist vorgesehen, daß als Kapazitätsmessungen komplexe Widerstandsmessungen durchgeführt werden. In diesem Fall ist es dann beispielsweise möglich, daß bei konstanter Wechselspannung einmal der Strom mit der positiven Gleichspannung und einmal der Strom mit der negativen Gleichspannung gemessen wird und daß aus der Differenz der beiden gemessenen Ströme auf die Polung des Kondensators geschlossen wird. Diese vereinfachte Messung wird durch die Wahl einer konstanten Wechselspannung mit konstanter Frequenz ermöglicht.

Eine andere vereinfachte Messung kann dadurch ermöglicht werden, daß einem eingeprägten konstanten Wechselstrom einmal ein Gleichstrom der einen Richtung und einmal ein Gleichstrom gleichen Betrags der anderen Richtung überlagert wird, daß jeweils parallel zum Kondensator die zugeordnete Spannung gemessen wird und daß aus der Differenz der beiden gemessenen Spannungen auf die Polung des Kondensators geschlossen wird.

Anstelle einer Strommessung bei konstanter Spannung oder einer Spannungsmessung bei konstantem Strom kann der komplexe Widerstand auch jeweils aus dem Verhältnis der gemessenen Spannung zu dem zugeordneten gemessenen Strom ermittelt werden. Derartige Messungen sind besonders genau, da sie auch die Widerstände der Leitungen berücksichtigen.

Eine besonders einfach aufgebaute und zuverlässige Einrichtung zur Durchführung des erfindungsgemäßen Verfahrens, bei der die eine Elektrode des zu prüfenden Kondensators mit dem Ausgang eines Wechselspannungsgenerators verbunden ist, ist dadurch gekennzeichnet, daß an die eine Elektrode des Kondensators zusätzlich der Ausgang eines Gleichspannungsgenerators zur abwechselnden Überlagerung einer positiven und einer negativen Gleichspannung gleichen Betrags angeschlossen ist, daß in Reihe zu dem Kondensator eine Strommeßeinrichtung angeordnet ist und daß die Differenz dieser abwechselnd gemessenen Ströme repräsentativ für die jeweilige Polarität des Kondensators ist.

Genauere Meßergebnisse durch Berücksichtigung der Leitungswiderstände können ggf. dadurch erreicht werden, daß parallel zu dem zu prüfenden Kondensator eine Spannungsmeßeinrichtung angeordnet ist. Der komplexe Widerstand kann dann aus dem Verhältnis der gemessenen Spannung zu dem gemessenen Strom ermittelt werden.

Gemäß einer bevorzugten Ausgestaltung der erfindungsgemäßen Einrichtung ist vorgesehen, daß der Strommeßeinrichtung eine Auswerteeinrichtung nachgeordnet ist. Der zur Auswertung erforderliche Vergleich der gemessenen Kapazitäten bzw. Ströme kann dann auf besonders einfache Weise dadurch erreicht werden, daß in der Auswerteeinrichtung ein Speicher für einen ersten Meßwert des Stromes angeordnet ist und daß einem nachgeordneten Komparator der gespeicherte erste Meßwert des Stromes und ein zweiter Meßwert des Stromes zuführbar sind. Das Ausgangssignal des Komparators kann dann beispielsweise dem Rechner eines Bestückautomaten zugeführt werden, so daß die Polaritätserkennung vor dem Absetzen des gepolten Kondensators in der zugeordneten Bestückposition ggf. durch eine Drehung des Bestückkopfes um 180° berücksichtigt werden kann.

Ein Ausführungsbeispiel der Erfindung ist in der Zeichnung dargestellt und wird im folgenden näher beschrieben.

Es zeigen

Fig. 1    einen Bestückkopf mit einem gepolten Kondensator und einer Polaritäts-Erkennungseinrichtung und

Fig. 2    den prinzipiellen Aufbau der in Figur 1 dargestellten Polaritäts-Erkennungseinrichtung.

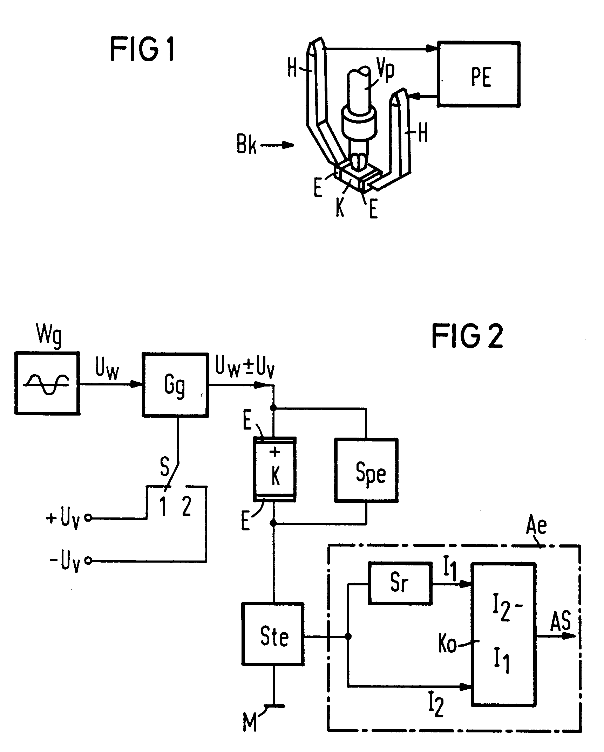

Fig. 1 zeigt einen von dem Bestückkopf Bk eines Bestückautomaten erfaßten Kondensator K. Von dem Bestückkopf Bk sind dabei lediglich eine Vakuumpipette Vp und zwei der insgesamt vier zur Zentrierung der aufgenommenen Bauteile vorgesehenen Hebel H zu erkennen.

Bei dem in Fig. 1 dargestellten Kondensator K handelt es sich um einen als SMD-Bauteil ausgebildeten gepolten Kondensator, beispielsweise um einen Tantal-Elektrolytkondensator. Somit ist eine der stirnseitigen Elektroden E dem positiven Pol und die andere Elektrode E dem negativen Pol zugeordnet. Da die lediglich auf einer Seite durch ein aufgedrucktes "+" aufgezeigte Polarität des Kondensators K vom Bestückautomaten nicht erkannt werden kann, ist dem Bestückkopf eine Polaritäts-Erkennungseinrichtung PE zugeordnet. Diese Polaritäts-Erkennungseinrichtung PE ist dabei an die beiden Hebel H angeschlossen, deren zangenförmige Enden die Elektroden E des vom Bestückkopf Bk aufgenommenen gepolten Kondensators K kontaktieren.

Fig. 2 zeigt in stark vereinfachter schematischer Darstellung die Funktionsweise und den prinzipiellen Aufbau der Polaritäts-Erkennungseinrichtung PE. Ein Wechselstromgenerator Wg erzeugt eine konstante, sinusförmige Wechselspannung $U_w$ mit einer konstanten Frequenz von 1 kHz und einer von Null aus gemessenen Amplitude von ± 0,25 Volt. In einem nachgeordneten Gleichstromgenerator Gg wird je nach Stellung eines Schalters S entweder eine konstante positive Gleichspannung + $U_v$ = 0,25 Volt oder eine konstante negative Gleichspannung - $U_v$ = 0,25 Volt erzeugt und der Wechselspannung $U_w$ überberlagert. In der in Fig. 2 dargestellten Stellung 1 des Schalters S wird somit eine resultierende Spannung $U_w$ + $U_v$ erzeugt, die sich sinusförmig zwischen einem unteren Wert Null und einem oberen Wert + 0,5 Volt ändert und somit keinen negativen Anteil aufweist. In der nicht dargestellten Stellung 2 des Schalters S wird demgegenüber eine resultierende Spannung $U_w - U_v$ erzeugt, die sich sinusförmig zwischen einem oberen Wert Null und einem unteren Wert -0,5 Volt ändert und somit keinen positiven Anteil aufweist.

Die mit dem Wechselstromgenerator Wg und dem Gleichstromgenerator Gg erzeugte resultierende Spannung $U_w + U_v$ oder $U_w - U_v$ ist an eine der Elektroden E des Kondensators K angelegt. Die andere Elektrode E des in Wirklichkeit gemäß Fig. 1 kontaktierten Kondensators K ist über eine in Reihe in den Stromkreis eingeschaltete Strommeßeinrichtung Ste an Masse M gelegt. Parallel zum jeweils zu prüfenden Kondensator K ist eine Spannungsmeßeinrichtung Spe angeordnet.

Der Strommeßeinrichtung Ste ist eine Auswerteeinrichtung Ae mit einem Speicher Sr und einem Komparator Ko nachgeordnet. Der Speicher Sr hat dabei die Aufgabe, den in der Stellung 1 des Schalters S von der Strommeßeinrichtung Ste gemessenen Strom $I_1$ zu speichern. Demgegenüber wird der in der Stellung 2 des Schalters S von der Strommeßeinrichtung Ste gemessene Strom $I_2$ unmittelbar dem Komparator Ko zugeführt. In dem Komparator Ko kann dann der gespeicherte Strom $I_1$ mit dem momentan ermittelten Strom $I_2$ verglichen werden, wobei die Differenz $I_2 - I_1$ ein für die Polarität des jeweiligen Kondensators K repräsentatives Ausgangs-Signal AS bildet, welches beispielsweise dem Rechner des Bestückautomaten zugeführt wird.

Mit der vorstehend geschilderten Einrichtung werden die Kapazitäten des Kondensators Ko in den Stellungen 1 und 2 des Schalters S gemessen. Diese Kapazitätsmessungen werden jedoch mittelbar über komplexe Widerstandsmessungen gemäß der Beziehung

$$R = \frac{1}{i \cdot \omega \cdot C}$$

durchgeführt, wobei mit R der Wechselstromwiderstand, mit $i$ die imaginäre Einheit $\sqrt{-1}$, mit $\omega$ die Kreisfrequenz der Wechselspannung $U_w$ und mit C die Kapazität des Kondensators K bezeichnet sind. Andererseits gilt die Beziehung

$$R = \frac{U}{I}$$

wobei mit $U = U_w + U_v$ oder $U = U_w - U_v$ die an den Kondensator K angelegte Spannung und mit $I = I_1$ oder $I = I_2$ oder mit der Strommeßeinrichtung Ste gemessene Strom bezeichnet sind. Demzufolge sind bei konstanter Spannung U und bei konstanter Kreisfrequenz $\omega$ der Strom I und die Kapazität C proportionale Größen.

Basierend auf der Erkenntnis, daß bei Elektrolytkondensatoren die gemessene Kapazität bei richtiger Polung geringer ist als bei falscher Polung ergibt sich für den in Fig. 2 dargestellten Fall, daß bei $I_1 < I_2$ eine richtige Polung angenommen werden kann, während bei $I_1 > I_2$ eine falsche Polung des Kondensators K angezeigt wird.

Gemäß Fig. 2 ist die obere Elektrode E des Kondensators K mit "+" bezeichnet, wobei der Bestückautomat diese Kennzeichnung der Polarität jedoch nicht erkennen kann. Die richtige Polarität wird jedoch dem Bestückautomaten durch das Ausgangs-Signal $AS = I_2 - I_1$ angezeigt. Im dargestellten Fall ist $I_1 < I_2$, d. h. der positive Wert des Ausgangs-Signals AS zeigt an, daß der Kondensator K in der Stellung 1 des Schalters S die richtige Polarität mit der kleineren Kapazität aufweist. Da in der Stellung 1 des Schalters S an der in Fig. 1 oberen Elektrode E des Kondensators K eine positive Spannung $U_w + U_v$ anliegt ergibt sich, daß die obere Elektrode E dem Pluspol und die untere Elektrode E dem Minuspol zugeordnet ist.

Würde der Kondensator K in Fig. 2 eine um 180° verdrehte Stellung einnehmen, so würde ein negativer Wert des Ausgangs-Signals AS anzeigen, daß nunmehr die untere Elektrode E dem Pluspol zugeordnet ist. In diesem Fall führt der Bestückkopf Bk (vgl. Fig. 1) vor dem Ablegen des Kondensators K in der Bestückposition eine Drehung um 180° aus.

Mit der vorstehend beschriebenen Polaritäts-Erkennungs-einrichtung PE an Tantal-Elektrolytkondensatoren durchgeführte Messungen ergaben bei richtiger Polung stets etwa 0,15 % geringere Kapazitätswerte als bei Falschpolung. Bei der beschriebenen Polaritäts-Erkennungseinrichtung PE wurde auch berücksichtigt, daß bei TantalElektrolytkondensatoren eine maximale Umpolspannung von 0,15 $U_{Nenn}$ bei 20° C und von 0,05 $U_{Nenn}$ bei 80° C und bei Aluminium-Elektrolytkondensatoren eine maximale Umpolspannung von 2 Volt nicht überschritten werden darf.

**Patentansprüche**

1. Verfahren zur Erkennung der Polarität gepolter Kondensatoren (K), insbesondere von Tantal- und Aluminium-Elektrolytkondensatoren bei der automatischen Bestückung von Leiterplatten oder Keramiksubstraten, bei dem die Kapazität eines zu prüfenden Kondensators (K) mittels einer Wechselspannung ($U_w$) ermittelt wird, **dadurch gekennzeichnet,** daß der Wechselspannung ($U_w$) abwechselnd eine positive Gleichspannung ($+U_v$) und eine negative Gleichspannung ($-U_v$) gleichen Betrags überlagert wird und daß aus der Differenz der beiden daraus ermittelten Kapazitäten die Polarität des Kondensators (K) bestimmt wird.

**2.** Verfahren nach Anspruch 1, dadurch **gekennzeichnet,** daß eine sinusförmige Wechselspannung ($U_w$) mit einer konstanten Frequenz verwendet wird.

**3.** Verfahren nach Anspruch 2, dadurch **gekennzeichnet,** daß eine Wechselspannung ($U_w$) mit einer von Null aus gemessenen Amplitude von ± 0,25 Volt verwendet wird.

**4.** Verfahren nach Anspruch 3, dadurch **gekennzeichnet,** daß der Wechselspannung ($U_w$) eine Gleichspannung ($+U_v$, $-U_v$) von ± 0,25 Volt überlagert wird.

**5.** Verfahren nach einem der vorhergehenden Ansprüche, dadurch **gekennzeichnet,** daß als Kapazitätsmessungen komplexe Widerstandsmessungen durchgeführt werden.

**6.** Verfahren nach Anspruch 5, dadurch **gekennzeichnet,** daß bei konstanter Wechselspannung ($U_w$) einmal der Strom ($I_1$) mit der positiven Gleichspannung ($+U_v$) und einmal der Strom ($I_2$) mit der negativen Gleichspannung ($-U_v$) gemessen wird und daß aus der Differenz ($I_2 - I_1$) der beiden gemessenen Ströme ($I_1$, $I_2$) auf die Polung des Kondensators (K) geschlossen wird.

**7.** Verfahren nach Anspruch 5, dadurch **gekennzeichnet,** daß einem eingeprägten konstanten Wechselstrom einmal ein Gleichstrom der einen Richtung und einmal ein Gleichstrom gleichen Betrags der anderen Richtung überlagert wird, daß jeweils parallel zum Kondensator (K) die zugeordnete Spannung gemessen wird und daß aus der Differenz der beiden gemessenen Spannungen auf die Polung des Kondensators (K) geschlossen wird.

**8.** Verfahren nach Anspruch 5, dadurch **gekennzeichnet,** daß der komplexe Widerstand jeweils aus dem Verhältnis der gemessenen Spannung zu dem zugeordneten gemessenen Strom ($I_1$, $I_2$) ermittelt wird.

**9.** Einrichtung zur Durchführung des Verfahrens nach einem der Ansprüche 1 bis 8, bei der die eine Elektrode (E) des zu prüfenden Kondensators (K) mit dem Ausgang eines Wechselspannungsgenerators (Wg) verbunden ist, dadurch **gekennzeichnet,** daß an die eine Elektrode des Kondensators (K) zusätzlich der Ausgang eines Gleichspannungsgenerators (Gg) zur abwechselnden Überlagerung einer positiven und negativen Gleichspannung ($+U_v$, $-U_v$) gleichen Betrags angeschlossen ist, daß in Reihe zu dem Kondensator (K) eine Strommeßeinrichtung (Ste) angeordnet ist und daß die Differenz dieser abwechselnd gemessenen Ströme ($I_1$, $I_2$) repräsentativ für die jeweilige Polarität des Kondensators (K) ist.

**10.** Einrichtung nach Anspruch 9, dadurch **gekennzeichnet,** daß parallel zu dem zu prüfenden Kondensator (K) eine Spannungsmeßeinrichtung (Spe) angeordnet ist.

**11.** Einrichtung nach Anspruch 9, dadurch **gekennzeichnet,** daß der Strommeßeinrichtung (Ste) eine Auswerteeinrichtung (Ae) nachgeordnet ist.

**12.** Einrichtung nach Anspruch 11, dadurch **gekennzeichnet,** daß in der Auswerteeinrichtung (Ae) ein Speicher (Sr) für einen ersten Meßwert des Stromes ($I_1$) angeordnet ist und daß einem nachgeordneten Komparator (Ko) der gespeicherte erste Meßwert des Stromes ($I_1$) und ein zweiter Meßwert des Stromes ($I_2$) zuführbar sind.

**Claims**

**1.** Method for identifying the polarity of polarised capacitors (K), preferably of tantalum and aluminium electrolytic capacitors during the automatic fitment of printed-circuit boards or ceramic substrates, in which the capacitance of a capacitor (K) which is to be tested is derived by means of an AC voltage ($U_w$), characterised in that a positive DC voltage ($+U_v$) and a negative DC voltage ($-U_v$) of the same magnitude are alternately superimposed on the AC voltage ($U_w$), and in that the polarity of the capacitor (K) is determined from the difference of the two capacitances derived therefrom.

**2.** Method according to Claim 1, characterised in that a sinusoidal AC voltage ($U_w$) at a constant frequency is used.

**3.** Method according to Claim 2, characterised in that an AC voltage ($U_w$) having an amplitude measured from zero of ± 0.25 Volts is used.

**4.** Method according to Claim 3, characterised in that a DC voltage ($+U_v$, $-Uv$) of ± 0.25 Volts is superimposed on the AC voltage ($U_w$).

**5.** Method according to one of the preceding claims, characterised in that complex impedance measurements are carried out as capacitance measurements.

6. Method according to Claim 5, characterised in that, with a constant AC voltage ($U_w$), on the one hand, the current ($I_1$) is measured with the positive DC voltage ($+U_v$) and, on the other hand, the current ($I_2$) is measured with the negative DC voltage (-$U_v$), and in that a decision is made on the polarity of the capacitor (K) from the difference ($I_2$ - $I_1$) of the two measured currents ($I_1$, $I_2$).

7. Method according to Claim 5, characterised in that, on the one hand, a DC current of the one polarity is superimposed on an applied constant AC current, and, on the other hand, a DC current of the same magnitude, of the other polarity, is superimposed on an applied constant AC current, in that the associated voltage is measured in each case in parallel with the capacitor (K), and in that a decision is made on the polarity of the capacitor (K) from the difference of the two measured voltages.

8. Method according to Claim 5, characterized in that the complex impedance is derived in each case from the ratio of the measured voltage to the associated measured current ($I_1$, $I_2$).

9. Device for carrying out the method according to one of Claims 1 to 8, in which the one electrode (E) of the capacitor (K) which is to be tested is connected to the output of an AC voltage generator (Wg), characterized in that the output of a DC voltage generator (Gg) is additionally connected to the one electrode of the capacitor (K) for alternately superimposing a positive and a negative DC voltage ($+U_v$, -$U_v$) of the same magnitude, in that a current measurement device (Ste) is arranged in series with the capacitor (K), and in that the difference of these alternately measured currents ($I_1$, $I_2$) is representative of the respective polarity of the capacitor (K).

10. Device according to Claim 9, characterized in that a voltage measurement device (Spe) is arranged in parallel with the capacitor (K) which is to be tested.

11. Device according to Claim 9, characterized in that an evaluation device (Ae) is arranged downstream of the current measurement device (Ste).

12. Device according to Claim 11, characterized in that a memory (Sr) for a first measured value of the current ($I_1$) is arranged in the evaluation device (Ae), and in that the stored first measured value of the current ($I_1$) and a second measured value of the current ($I_2$) can be supplied to a comparator (Ko) arranged downstream.

**Revendications**

1. Procédé pour identifier la polarité de condensateurz polarisés (K), notamment de condensateurs électrolytiques au tantale et à aluminium, lors de l'équipement automatique de plaquettes à circuits imprimés ou de substrats céramiques, selon lequel la capacité d'un condensateur à contrôler (K) est déterminée à l'aide d'une tension alternative ($U_w$),
caractérisé par le fait
qu'alternativement une tension continue positive ($+U_v$) et une tension continue négative (-$U_v$) de même valeur est superposée à la tension alternative ($U_w$) et que la polarité du condensateur (K) est déterminée à partir de la différence des deux capacités déterminées à partir de là.

2. Procédé suivant la revendication 1, caractérisé par le fait qu'on utilise une tension alternative sinusoïdale ($U_w$) possédant une fréquence constante.

3. Procédé suivant la revendication 2, caractérisé par le fait qu'on utilise une tension alternative ($U_w$) possédant une amplitude de ±0,25 volt, mesurée à partir du zéro.

4. Procédé suivant la revendication 3, caractérisé par le fait qu'une tension continue ($+U_v$,-$U_v$) égale à ±0,25 volt est superposée à la tension alternative ($U_w$).

5. Procédé suivant l'une des revendications précédentes, caractérisé par le fait qu'on exécute comme mesures de capacité, des mesures complexes de résistance.

6. Procédé suivant la revendication 5, caractérisé par le fait que, dans le cas d'une tension alternative ($U_w$) constante, on mesure une fois le courant ($I_1$) avec la tension continue positive ($+U_v$) et une fois le courant ($I_2$) avec la tension continue négative (-$U_v$) et qu'on détermine la polarité du condensateur (K) à partir de la différence ($I_2$-$I_1$) des deux courants mesurés ($I_1$,$I_2$).

7. Procédé suivant la revendication 5, caractérisé par le fait qu'on superpose une fois un courant continu possédant un sens et une fois un courant continu possédant la même valeur et l'autre sens à un courant alternatif constant injecté, qu'on mesure la tension associée respectivement en parallèle avec le condensateur (K) et qu'on détermine la polarité du condensateur (K) à partir de la différence des deux tensions mesurées.

8. Procédé suivant la revendication 5, caractérisé par le fait qu'on détermine la résistance complexe respectivement à partir du rapport de la tension mesurée au courant mesuré associé ($I_1$, $I_2$).

9. Dispositif pour la mise en oeuvre du procédé suivant l'une des revendications 1 à 8, selon lequel une première électrode (E) du condensateur (K) à contrôler est raccordée à la sortie d'un générateur de tension alternative (Wg), caractérisé par le fait qu'à la première électrode du condensateur (K) est en outre raccordée la sortie d'un générateur de tension continue (Gg) permettant de superposer alternativement une tension continue positive et négative ($+U_v$, $-U_v$) de même valeur, qu'un dispositif (Ste) de mesure du courant est monté en série avec le condensateur (K) et que la différence entre ces courants ($I_1$, $I_2$) mesurés alternativement est représentative de la polarité respective du condensateur (K).

10. Dispositif suivant la revendication 9, caractérisé par le fait qu'un dispositif (Spe) de mesure de la tension est monté en parallèle avec le condensateur (K) à contrôler.

11. Dispositif suivant la revendication 9, caractérisé par le fait qu'un dispositif d'évaluation (Ae) est branché en aval du dispositif (Ste) de mesure du courant.

12. Dispositif suivant la revendication 11, caractérisé par le fait qu'une mémoire (Sr) pour une première valeur de mesure du courant ($I_1$) est disposée dans le dispositif d'évaluation (Ae) et que la première valeur de mesure mémorisée du courant ($I_1$) et une seconde valeur de mesure du courant ($I_2$) peuvent être envoyées à un comparateur (Ko) branché en aval.

FIG 1

FIG 2